# EUROPEAN PATENT SPECIFICATION

(11) **EP 1 987 399 B1**
(45) Date of publication and mention of the grant of the patent: **22.05.2013**
(21) Application number: 07717064.5
(22) Date of filing: 25.01.2007
(51) Int. Cl.: G03F 7/24, G03F 9/00, G03F 7/20

(54) **MERGING A MASK AND A PRINTING PLATE**
ZUSAMMENFÜGUNG EINER MASKE UND DRUCKPLATTE
REUNION D'UN MASQUE ET D'UNE PLAQUE D'IMPRESSION

(30) Priority: 24.02.2006 US 361492
(43) Date of publication of application: 05.11.2008
(73) Proprietor: Eastman Kodak Company, Rochester, NY 14650-2201 (US)
(72) Inventor: ZWADLO, Gregory, Lloyd, River Falls, WI 54022 (US)
(74) Representative: Vossius & Partner
(86) International application number: PCT/US2007/002222
(87) International publication number: WO 2007/106241

(56) References cited:
- WO-A-00/46641
- WO-A2-02/065215
- AT-B- 342 969
- DE-A1- 3 312 587
- DE-A1- 10 144 579
- GB-A- 2 232 930
- JP-A- 56 064 344

## Description

### FIELD OF THE INVENTION

This invention relates to the field of flexography. In particular, this invention pertains to merging a mask with a flexible printing plate, so that an image may be formed on the printing plate via the mask.

### BACKGROUND OF THE INVENTION

Flexography is a process for forming images on various absorbent and non-absorbent materials (or "printing substrates"), such as plastics, foils, brown paper, or cardboard, using a flexible printing plate, such as a plastic printing plate or a rubber printing plate. Because the printing plates used in flexographic printing are flexible, they are often referred to as "flexo plates." Prior to forming an image on a printing substrate, a relief image having slightly raised image components is formed on the printing plate. When ink is applied to the printing plate, the raised image components on the printing plate are used to transfer the relief image to a printing substrate. The inks used in flexographic printing are fast-drying and, consequently, accommodate high-speed printing. Further, because the printing plates are flexible, they may be wrapped around a "plate cylinder." In order to form images on printing substrates, the plate cylinder is rotated while the printing plate formed thereon is contacted with a printing substrate. Such an arrangement allows the formation of continuous patterns, such as wallpaper patterns.

One conventional scheme for forming a relief image onto a printing plate involves forming a black material (i.e., a carbon black particulate in a blinder), or mask, directly on top of a flexible printing plate wrapped around a cylinder, or "sleeve mandrel."

The printing plate and black material formed together are referred to as an "integral mask." The sleeve mandrel with integral mask formed thereon is rotated in view of a laser, such that portions of the black material are removed by laser-ablation. After ablation, the combination of the ablated black material and the printing plate are subjected to ultraviolet ("UV") radiation to form the relief image on the printing plate. The printing plate has a thick (about 0.045 inches to 0.25 inches or larger) photopolymer layer responsive to the UV radiation formed on top of a polyester substrate. As the combination of the ablated black material and the printing plate are subjected to UV radiation, the exposed portions of the printing plate's photopolymer layer, i.e., the portions of the photopolymer layer not covered by the black material, react with the UV radiation and become "crosslinked."

After being subjected to UV radiation, the combination of the ablated black material and the printing plate are subjected to a processing step that washes such combination with a chemical, known in the art. The black material and the uncrosslinked portions of the printing plate's photopolymer layer are soluble with the chemical and are washed off. The crosslinked portions of the printing plate's photopolymer layer are not soluble with the chemical and remain on the printing plate. These remaining portions of the photopolymer layer are now raised above the printing plate's polyester substrate and, collectively, form the relief image on the printing plate.

After the relief image is formed on the printing plate, the printing plate may remain on the sleeve mandrel, and the sleeve mandrel may be used as the plate cylinder to form images on printing substrates. A drawback of this conventional scheme is that the sleeve mandrel is a non-standard expensive part that replaces the standard plate cylinders found in printing devices. Another drawback of this conventional scheme is that the carbon mask must be pre-coated on the sleeve mandrel and imaged in a special sleeve mandrel handling imager.

Accordingly, a need in the art exists for a simple and cost effective way to form a relief image onto a printing plate.

### SUMMARY OF THE INVENTION

U.S. Patent Application 11/081,018, published as U.S. Patent Application Publication 2005/0227182A1, describes forming an image into a mask prior to merging the mask with a printing plate. That is, the mask is pre-imaged. The pre-imaged mask is then placed in contact with the printing plate, and the combination of the mask and the printing plate are exposed to UV radiation to form a relief image onto the printing plate through the mask. The printing plate and the mask are subsequently separated, and the printing plate may then be used to form images on printing substrates. An advantage of this process for forming a relief image on a printing plate is that the pre-imaged mask can be "soft-proofed," or checked for quality while it is free-standing prior to being merged with the printing plate. However, because the pre-image masked is free-standing prior to being merged with the printing plate, it can be a challenge to properly align the pre-imaged mask with the printing plate.

The present invention according to claim 1 relates to a method for merging a mask and a printing plate, the method comprising the steps of:
receiving the mask, the mask having an opening;
placing the mask at least partially around a first cylinder such that the opening in the mask is aligned with a protrusion on the first cylinder;
merging the mask and the printing plate by at least (a) aligning the protrusion on the first cylinder with an indent on a second cylinder, and (b) rotating at least one of the first cylinder and the second cylinder;
and exposing the merged mask and printing plate to radiation to form the image into or onto the printing plate;
wherein the mask has an image formed into it or onto it by laser ablation prior to or subsequent to placing the mask at least partially around the first cylinder;
and wherein the printing plate is formed at least partially around the second cylinder. Further embodiments are described in the dependent claims.

The use of the protrusion on the first cylinder and the indent on the second cylinder allow for alignment of the mask and the printing plate to be performed with ease. Further, the second cylinder may be.a standard plate cylinder, thereby reducing costs over conventional methods that require the use of non-standard cylinders.

According to an embodiment of the invention, the mask, prior to being imaged, is placed on an imaging cylinder and imaged. The imaging cylinder with the imaged-mask thereon, is then used as the first cylinder, referred to in the above-discussed embodiments, to merge the mask with the printing plate. These embodiments are useful when it is not desirable to have a free-standing mask that must be placed on another cylinder prior to being merged with the printing plate.

According to still another embodiment of the present invention, the mask and the printing plate are merged such that the mask overlaps itself. The mask overlap may or may not be removed. An advantage of this embodiment is that the printing plate is completely covered by the mask, whether or not the mask overlap is removed, which prevents the buildup of ridges at exposed edges of the printing plate when undergoing UV exposure. According to an embodiment of the present invention, the mask overlap is removed using a scribe line.

In addition to the embodiments described above, further embodiments will become apparent by reference to the drawings and by study of the following detailed description.

### BRIEF DESCRIPTION OF THE DRAWINGS

The present invention will be more readily understood from the detailed description of exemplary embodiments presented below considered in conjunction with the attached drawings, of which:
FIG. 1 illustrates a mask drum and a sleeve cylinder, according to an embodiment of the present invention;
FIG. 2 illustrates the transfer of a mask to a printing plate using a protrusion and an indent, according to an embodiment of the present invention;
FIG. 3 illustrates overlapping of a mask to ensure complete coverage of a printing plate, according to an embodiment of the present invention;
FIG. 4 illustrates exposure of the merged mask and printing plate to a radiation source to form a relief image on the printing plate, according to an embodiment of the present invention;
FIG. 5 illustrates a scribe line and tape that may be used to assist in the removal of portions of the mask;
FIGS. 6A and 6B illustrate the transfer of a mask to a printing plate using markings;
FIG. 7 illustrates the transfer of a mask to a printing plate using one or more encoders;
FIG. 8A illustrates the transfer of a mask on a mask drum to a printing plate on a flat-like surface;
FIG. 8B illustrates the transfer of a mask on a mask drum to a printing plate on a flat-like surface using a sleeve cylinder; and
FIG. 9 illustrates an imaging apparatus using the printing plate having the relief image formed thereon to form an image on a printing substrate;

It is to be understood that the attached drawings are for purposes of illustrating the concepts of the invention and may not be to scale.

### DETAILED DESCRIPTION

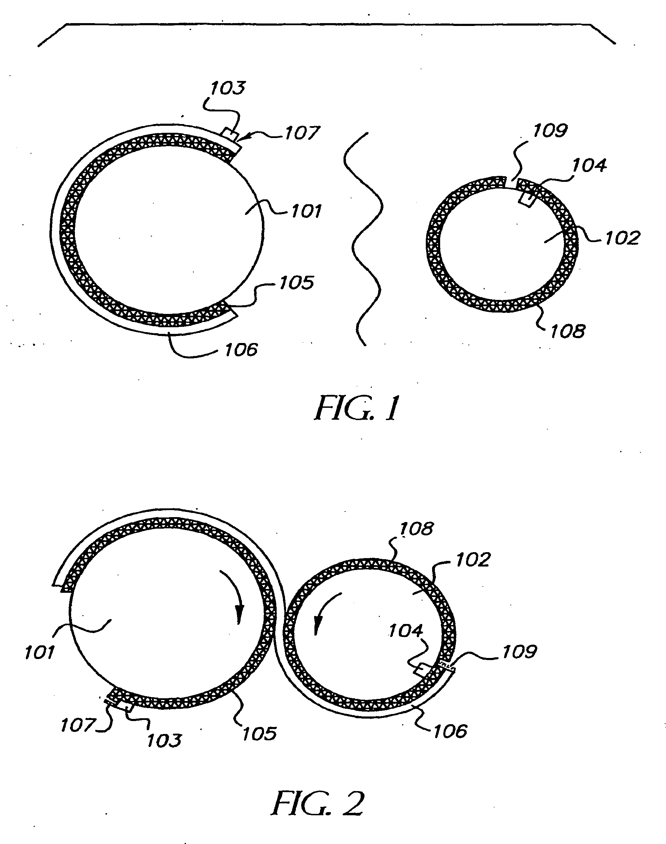

FIG. 1 illustrates a mask drum 101 and a sleeve cylinder 102, according to an embodiment of the present invention. (The words "drum" and cylinder" are used interchangeably.) As shown in FIG. 1, the mask drum 101 has a protrusion 103 that fits into an indent 104 in the sleeve cylinder 102. The protrusion 103 and the indent 104 can have any shape, so long as the protrusion 103 and the indent 104 fit together in a manner that securely registers the mask drum 103 and the sleeve cylinder 104. The mask drum 101 has formed on it a mask substrate 105 and a mask 106 formed on top of the mask substrate 105. The mask substrate 105 should be suitably flat for the mask 106 and may be any material known in the art, such as plastic sheets and films, such as, for example, polyethylene terephthalate or polyethylene naphthalate, fluorene polyester polymers, polyethylene, polypropylene, acrylics, polyvinyl chloride and copolymers thereof, and hydrolyzed and non-hydrolyzed cellulose acetatepolyester, as described in U.S. Patent Application Publication No. 2005-0227182 (Ali, et al.). Further, the mask substrate 105 should have the quality of allowing easy transfer of the mask 106 to the printing plate 108.

According to an embodiment of the present invention, the mask 106 is a laminatable mask, and in particular, a Laser Ablatable Transfer Mask using the Dye Ablative System ("DAS") media. According to an embodiment of the present invention, the mask 106 is imaged according to the processes described in U.S. Patent Application Publication No., prior to being placed on the mask drum 101. In another embodiment of the present invention, the mask 106 is imaged on the mask drum 101, such that the mask drum 101 also serves as an imaging drum. This embodiment is useful when having a free-standing mask that must subsequently be placed on the mask drum 101 is undesirable.

The mask substrate 105 and the mask 106 each have an opening 107 formed in them that corresponds to the protrusion 103. As part of the pre-imaging process of the mask 106, a registration mark may be formed on the mask 106 that may be used to indicate where the opening 107 in the mask 106 is to be formed. Optionally, the opening 107 may be formed where the registration mark on the mask 106 is located.

The sleeve cylinder 102, according to an embodiment of the present invention, has the printing plate 108 formed thereon. The printing plate 108 may be a flexo plate, and in particular, an Eastman Kodak Company Flexcel SRH flexographic printing plate 0.047 inches thick. (Flexcel is a registered trademark of Kodak Polychrome Graphics, LLC ofNorwalk, CT.) Optionally, the sleeve cylinder 108 may include a pre-mounted flexographic printing plate using sticky-back tape. The printing plate 108, shown in FIG. 1, has a seam 109 where leading and trailing edges of the printing plate 108 exist. However, a premanufactured flexo-sleeve (seamless) cylinder with the printing plate molded thereon may be used. In this case, no seam 109 would exist.

The printing plate 108 in FIG. 1 is shown as overlapping the indent 104. In this situation, the printing plate 108 has an opening formed therein that corresponds to the indent 104. However, the indent 104 may be located away from the printing plate 108 such that printing plate 108 need not overlap the indent 104. In this situation, the printing plate 108 does not need to have an opening formed therein.

FIG. 2 illustrates the transfer of the mask 106 to the printing plate 108, according to an embodiment of the present invention. At the initiation of merging the mask 106 and the printing plate 108, the protrusion 103 is aligned with the indent 104, and the mask 106 is brought into contact with the printing plate 108 with proper registration. The mask drum 101 and the sleeve cylinder 102 are in close enough proximity to provide moderate transfer pressure on the order of two to five pounds per linear inch (13789.52 N/m² to 34 473.8 N/m²) between the mask 106 and the printing plate 108. Typically, the outer surface of the printing plate 108 is adhesive in nature, and therefore, moderate transfer pressure is sufficient to merge the mask 106 and the printing plate 108. However, in cases where the outer surface of the printing plate 108 is not adhesive in nature, for example, because of the application of an anti-tack layer to the printing plate 108, heat may be applied along with pressure to merge the mask 106 and the printing plate 108. Depending upon what type of printing plate 108 is used, more or less pressure may need to be applied. Once the mask 106 and the printing plate 108 have been contacted, the mask drum 101 and the sleeve cylinder 102 are rotated in opposite directions so that the entire mask 106 is transferred to the sleeve cylinder 102.

As shown in FIG. 2, the mask 106 separates from the mask substrate 105 at the point of transfer. Such separation occurs automatically as the mask drum 101 and the sleeve cylinder 102 rotate. This arrangement allows a relatively thin mask 106 to be transferred to the printing plate 108 without having to use a relatively thick mask substrate.

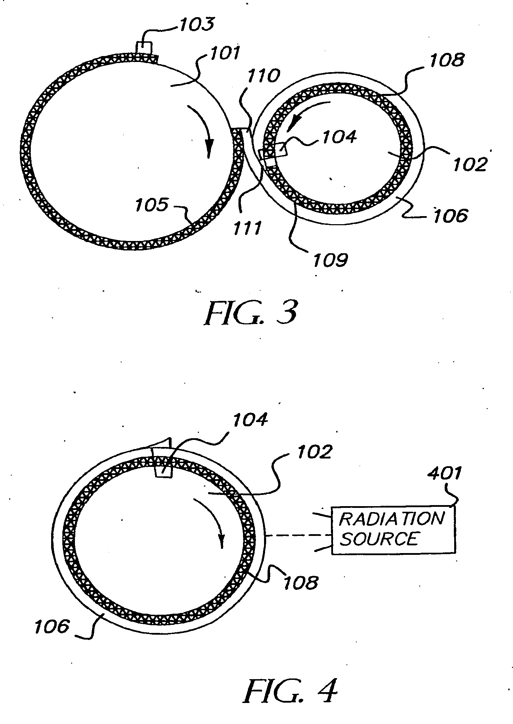

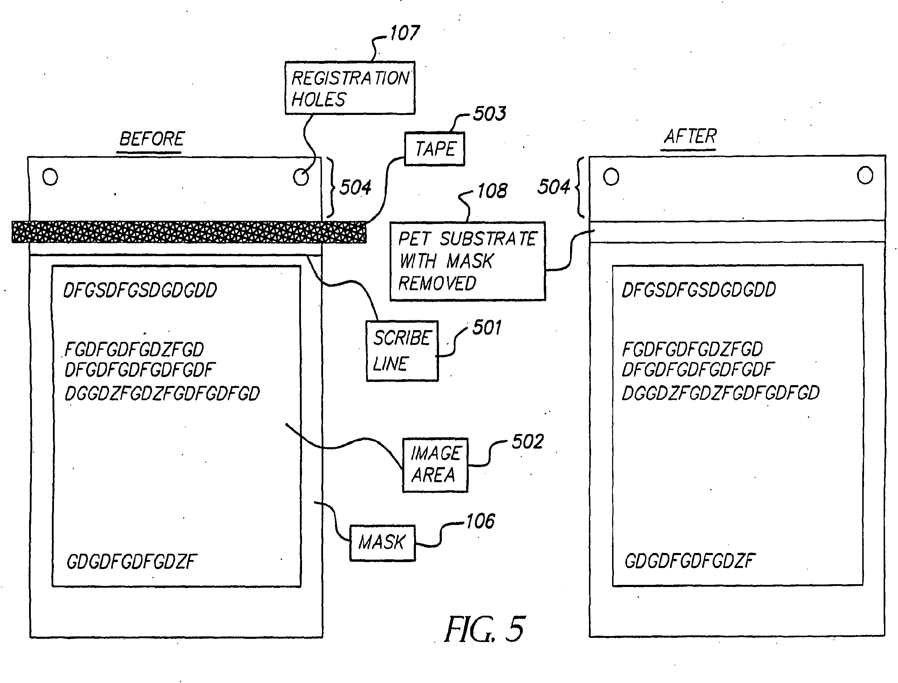

Turning now to FIG. 3, in the event that the printing plate 108 has a seam 109, the mask 106 may be transferred to the sleeve cylinder 102 such that the trailing edge 110 of the mask 106 overlaps the leading edge 111 of the mask 106 so that the seam 109 is covered. An advantage of this arrangement is that it prevents the formation of ridges on the leading and trailing edges of the printing plate 108 during subsequent radiation exposure. Because the mask 106 is typically very thin, on the order of a few microns thick, the overlap often is not troublesome. However, the overlap may be removed, as described in more detail with respect to FIG. 5.

FIG. 5 illustrates the mask 106 having an image formed therein in an image area 502 prior to being merged with the printing plate 108. A scribe line 501 may be formed in the mask 106 to assist in the uniform removal of the portion of the mask 106 that overlaps itself. The scribe line 501 may be formed in the mask 106 by laser-etching or by partial cutting with a razor. After the mask 106 is merged with the printing plate 108, the portion 504 "ahead" of the scribe line 501 (i.e., a portion of the mask 106 on a side of the scribe line 501 away from an image area 502 in the mask 106), which may include some or all of the overlapping portion of the mask, may be removed by smoothly tearing the mask 106 along the scribe line 501. To further assist in removing a portion 504 of the mask 106 "ahead" of the scribe line 501, tap 503 may be used to prevent adhering of the mask 106 to the printing plate 108 during merging. After merging of the mask 106 and the printing plate 108, the tape 503 may be removed making it easier to tear the mask 106 along the scribe line 501. Alternatively, the tape 503 may be removed prior to merging of the mask 106 and the printing plate 108 in order to provide a crisp edge for the mask to blend into at the end of the rotation ("trailing edge")).

After the mask 106 and the printing plate 108 have been merged, the sleeve cylinder 102 (along with the merged mask 106 and printing plate 108) may be subjected to radiation to crosslink the portions of the printing plate's photopolymer layer exposed through the mask 106. According to one embodiment of the present invention, as shown in FIG. 4, a radiation source 401 transmits radiation, such as UV radiation to the sleeve cylinder 102. As the sleeve cylinder 102 rotates, the radiation passes through portions of the mask 106 that were removed by the pre-imaging process and strikes the exposed portions of the printing plate's photopolymer layer (not shown) to crosslink such portions. A suitable product for performing this UV exposure is the "Round UV Exposure Unit" by AV Flexologic of the Netherlands. Subsequent to the UV exposure, the merged mask 106 and printing plate 108 are subjected to chemical washing, as is known in the art, to remove the mask 106 and the crosslinked portions of the printing plate's photopolymer layer. A suitable product for performing this chemical washing is AV Flexologic's "Sleeve Washout Unit". The remaining uncrosslinked portions of the printing plate's photopolymer layer form the relief image on the printing plate 108.

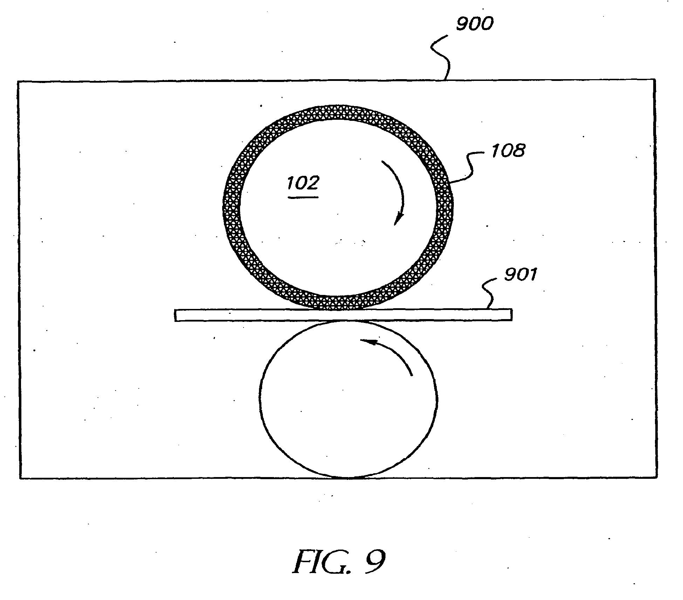

After the relief image is formed on the printing plate 108, the printing plate may be used to form images on printing substrates. For example, FIG. 9 illustrates an imaging apparatus 900 including the sleeve cylinder 102 having the printing plate 108 (with the relief image) formed thereon. The sleeve cylinder 108 rotates in order to transfer ink (not shown) from the printing plate 108 to a printing substrate 901.

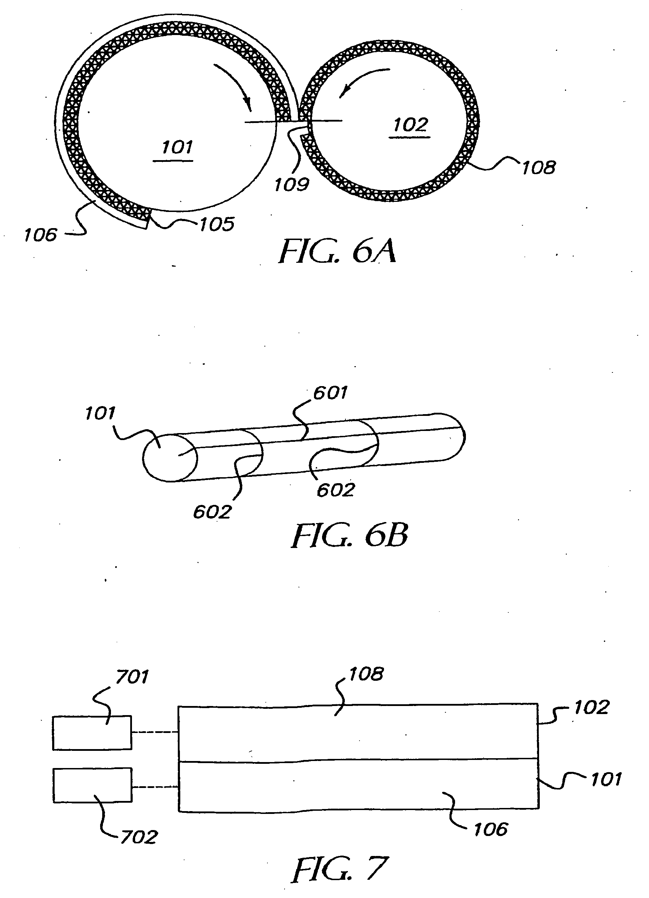

FIGS. 6-8 illustrate other methods which provide different solutions for merging the mask 106 and the printing plate 108. FIG. 6A illustrates the transfer of the mask 106 to the printing plate 108 using a first marking 601 on the mask drum 101 that is aligned with a second marking 602 on the sleeve cylinder 102, according to an embodiment of the present invention. According to this embodiment, the mask substrate 105 and the mask 106 are placed on the mask drum 101 in alignment with the first marking 601. Similarly, the printing plate 108 is formed on the sleeve cylinder 102 in alignment with the second marking 602.

The first marking 601 may be on one or both ends of the mask drum 101, on the outer circumference of the mask drum 101, or both. For instance, as shown in FIG. 6B, the first marking 601 may be a line that begins on an end of the mask drum 101, extends radially outward toward an edge of the mask drum 101, then extends along the outer circumference of the mask drum 101 in a length-wise direction toward the other edge of the mask drum 101, and then extends radially inward toward the center of the other end of the mask drum 101. The first marking 601 need not be a line, and can be any sort of marking, such as an arrow, a dot, a symbol, etc. Further, the first marking 601 may include a plurality of separate markings. One skilled in the art will appreciate that the invention is not limited to any particular type or arrangement of marking(s). The second marking 602 may be the same as the first marking 601, or may be different, so long as the first marking 601 and the second marking 602 assist in the angular alignment of the mask 106 and the printing plate 108. Additionally, corresponding markings may be provided on an outer circumference of the mask drum 101 and the sleeve cylinder 102 to assist in aligning the mask 106 and the printing plate 108 along the lengths of the mask drum 101 and the sleeve cylinder 102. For example, as shown in FIG. 6B, markings 602 may be provided on the mask drum 101, and corresponding markings (not shown) maybe provided on the sleeve cylinder 102. Such markings may be the same or different and may or may not line up, depending upon how the mask 106 and the printing plate 108 are to be aligned. Further, such markings may extend fully or partially around the circumferences of the mask drum 101 and the sleeve cylinder 102, or may be points that do not extend around the circumferences of the mask drum 101 and the sleeve cylinder 102.

FIG. 7 illustrates the transfer of the mask 106 to a printing plate 108 using one or more encoders 701, 702. According to this method, one or more encoders 701, 702, which may be absolute encoders, incremental encoders, and may be optical encoders, as known in the art, are used to provide the angular position of one or both of the mask drum 101 and the sleeve cylinder 102. The data from the one or more encoders 701, 702 is used to properly align the mask drum 101 with the sleeve cylinder 102, so that the mask 106 and the printing plate 108 are in proper alignment. This aspect may be used in combination with the aspect of FIG. 6A, such that one of the mask drum 101 and the sleeve cylinder 102 has an encoder to detail its angular position, and the other of the mask drum 101 and the sleeve cylinder 102 has a marking on it to indicate its angular position.

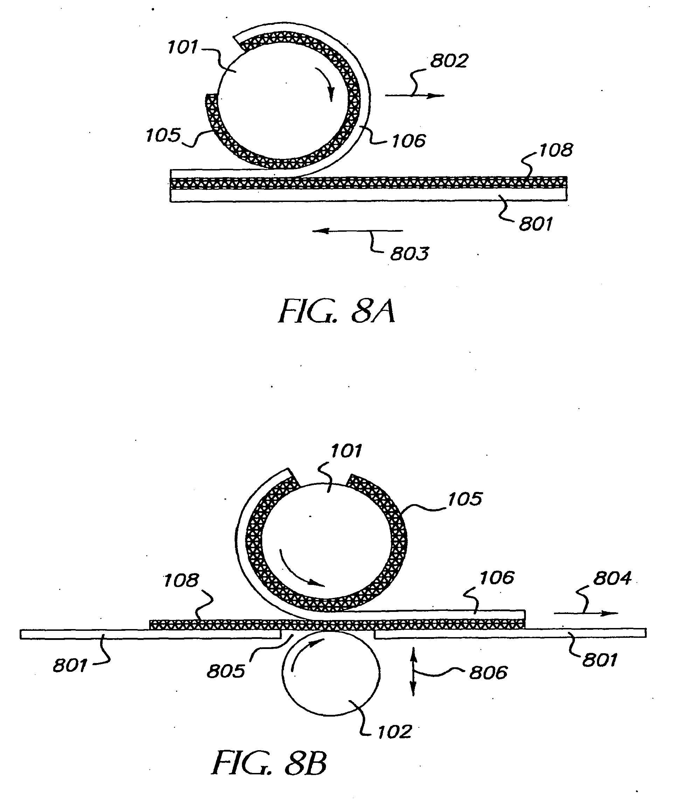

FIG. 8A illustrates the transfer of the mask 106 to the printing plate 108, which is on a substantially flat surface 801. The flat surface 801 may be made of metal, glass, plexiglass, etc. One skilled in the art, however, will appreciate that it is not limited to any particular material for the flat surface 801. The printing plate 108 may merely be laid flat on the surface 801 or may be clamped to the surface 801. According to an aspect, the mask 106 and the printing plate 108 may be aligned using a protrusion and an indent, an encoder, and/or markings as previously described. Once aligned and in contact, the mask drum 101, which may or may not also act as an imaging drum, may rotate while moving in a direction 802 substantially parallel to the flat surface 801 and while the flat surface 801 remains stationary, in order to merge the mask 106 and the printing plate 108. Alternatively, the flat surface 801 may move in a direction 803 tangential to the mask drum 101, while the mask drum 101 remains stationary, but rotates, in order to merge the mask 106 and the printing plate 108. Further, the flat surface 801 may move in the direction 803 while the mask drum 101 moves in the direction 802 and rotates, in order to merge the mask 106 and the printing plate 108. This aspect is advantageous when the merged mask 106 and printing plate 108 are to be exposed to UV radiation while on the flat surface 801, instead of "in-the-round" UV exposure as described with respect to FIG. 4. Alternatively, the merged mask 106 and printing plate 108 could be moved from the flat surface 801 to a sleeve cylinder prior to being exposed to UV radiation. Either way, the printing plate 108, subsequent to UV exposure and any subsequent chemical washing, likely will be placed on a sleeve cylinder in order to form images on printing substrates 901, as described with respect to FIG. 9.

FIG. 8B illustrates a variation of the embodiment of FIG. 8A by forming an opening or gap 805 in the flat surface 801 and using the sleeve cylinder 102 to assist merging of the mask 106 and the printing plate 108. Note that the opening in the flat surface 801 may split the flat surface 801 into two separate flat surfaces, or may be an opening in a single flat surface. An example of the printing plate 108, according to this embodiment, is an Eastman Kodak Company Flexcel SRH flexographic printing plate 0.067 inches thick. According to the embodiment of FIG. 8B, the sleeve cylinder 102 is configured to move between an engaged position (up as shown in FIG. 8B), where pressure is applied to the mask 106 and the printing plate 108 between the mask drum 105 and the sleeve cylinder 102, and a disengaged position (down as shown in FIG. 8B) where the sleeve cylinder 102 is removed from the mask drum 105 and no pressure is applied between the mask drum 105 and the sleeve cylinder 102. In order to merge the mask 106 and the printing plate 108, the sleeve cylinder 102 is moved into the engaged position, and the mask 106 and the printing plate 108 are aligned. The mask 106 and the printing plate 108 may be aligned using a protrusion and an indent, an encoder, and/or markings as previously described. The mask drum 101 and the sleeve cylinder 102 are rotated in corresponding directions while the mask 106 and the printing plate 108 are moved in direction 804 under moderate transfer pressure, such as approximately 2-5 points per linear inch. If the printing plate 108 is adhesive in nature, low or room temperature is sufficient to accomplish merging. To assist in the release of the mask 106 from the mask substrate 105, the mask drum 101 may be a drum with vacuum hold-down, known in the art. As with all other embodiments, the mask drum 101 may serve the dual purpose of also acting as the imaging drum. After merging, the combined mask 106 and printing plate 108 may be exposed to standard or in-the-round UV exposure and subsequent chemical washing, as previously described.

It is to be understood that the exemplary embodiments are merely illustrative of the present invention and that many variations of the above-described embodiments can be devised by one skilled in the art without departing from the scope of the invention. For example, although some embodiments of the present invention are described in the context of using a pre-imaged mask, one skilled in the art will appreciate that the present invention applies to merging non-pre-imaged masks and printing plates. Further, the present invention may be used to bring into contact any two materials capable of being formed on a cylinder. For another example, although FIGS. 2, 3, 6A, and 7 show rotation of both a mask drum 101 and a sleeve cylinder 102 during merging of the mask 106 and the printing plate 108, rotation of one of the mask drum 101 and the sleeve cylinder 102 around the other while the other remains stationary is possible. For yet another example, the indent 104 and the protrusion 107 may be reversed, so that the protrusion 107 is formed on the sleeve cylinder 102 and the indent 104 is formed on the mask drum 101. Also, more than one protrusion and indent combination may be present. All that is required is a mechanism that properly aligns, the mask 106 and printing plate 108. Accordingly, other mechanisms in combination with or besides one or more protrusions and indents may be used, so long as the mask 106 and the printing plate 108 can be properly aligned. For still yet another example, although the surface 801 in FIGS. 8A and 8B is shown and described as being flat, one skilled in the art will appreciate that such surface need not be flat and may be rounded or have an angle in it. Further, if the surface 801 in FIG. 8B is actually comprised of two or more separate surfaces separated at least by opening 805, such two or more surfaces need not be parallel. Accordingly, to encompass these variations in the surface 801, the claims may refer to a "flat-like" surface. In addition, although FIG. 8B shows the sleeve cylinder 102 as being moveable to an engaged or disengaged position, one skilled in the art will appreciate that the mask drum 101 could also or instead be moveable in a similar engaged/disengaged position.

### PARTS LIST

| | |
|---|---|
| 101 | Mask Drum |
| 102 | Sleeve Cylinder |
| 103 | Protrusion |
| 104 | Indent |
| 105 | Mask Substrate |
| 106 | Mask |
| 107 | Opening |
| 108 | Printing Plate |
| 109 | Seam |
| 110 | Leading Edge of Mask 106 |
| 111 | Trailing Edge of Mask 106 |
| 401 | Radiation Source |
| 501 | Scribe Line |
| 502 | Image Area |
| 503 | Tape |
| 504 | Portion of the Mask 106 |
| 601 | First Marking |
| 602 | Second Marking |
| 701 | Encoder |
| 702 | Encoder |
| 801 | Flat Surface |
| 802 | Direction of Mask Drum 101 |
| 803 | Direction of Flat Surface |
| 804 | Direction of printing plate 108/Mask 106 |
| 805 | Opening/Gap in Flat Surface 801 |
| 806 | Engaged/Disengaged Position of Sleeve Cylinder 102 |
| 900 | Imaging Apparatus |
| 901 | Printing Substrate |

## Claims

1. A method for merging a mask and a printing plate, the method comprising the steps of:
receiving the mask, the mask having an opening;
placing the mask at least partially around a first cylinder such that the opening in the mask is aligned with a protrusion on the first cylinder;
merging the mask and the printing plate by at least (a) aligning the protrusion on the first cylinder with an indent on a second cylinder, and (b) rotating at least one of the first cylinder and the second cylinder;
and exposing the merged mask and printing plate to radiation to form the image into or onto the printing plate;
wherein the mask has an image formed into it or onto it by laser ablation prior to or subsequent to placing the mask at least partially around the first cylinder;
and wherein the printing plate is formed at least partially around the second cylinder.

2. The method of claim 1, further comprising the step of separating the mask from the printing plate subsequent to radiation exposure.

3. The method of claim 1, wherein the radiation is ultraviolet radiation.

4. The method of claim 1, wherein the mask and the printing plate are merged such that the mask overlaps itself.

5. The method of claim 4, wherein the mask overlap is removed.

6. The method of claim 4, wherein the mask overlap is removed by use of a scribe line.

7. The method of claim 1, wherein the first cylinder and the second cylinder are rotatable.

## Patentansprüche

1. Ein Verfahren zum Zusammenfügen einer Maske und einer Druckplatte, wobei das Verfahren die Schritte umfasst:
Erhalten der Maske, wobei die Maske eine Öffnung aufweist;
Platzieren der Maske mindestens teilweise um einen ersten Zylinder herum, sodass die Öffnung in der Maske auf einen Vorsprung auf dem ersten Zylinder ausgerichtet ist;
Zusammenfügen der Maske und der Druckplatte durch mindestens (a) Ausrichten des Vorsprungs auf dem ersten Zylinder auf eine Vertiefung auf einem zweiten Zylinder und (b) Rotieren von mindestens einem aus dem ersten Zylinder und dem zweiten Zylinder;
und Bestrahlen der zusammengefügten Maske und Druckplatte zum Erzeugen des Bildes in oder auf der Druckplatte;
wobei die Maske ein Bild aufweist, das durch Laserablation darin oder darauf gebildet wurde, bevor oder nachdem die Maske mindestens teilweise um den ersten Zylinder herum platziert wird;
und wobei die Druckplatte mindestens teilweise um den zweiten Zylinder herum gebildet wird.

2. Das Verfahren nach Anspruch 1, ferner umfassend den Schritt des Trennens der Maske von der Druckplatte nach der Bestrahlung.

3. Das Verfahren nach Anspruch 1, wobei die Strahlung UV-Strahlung ist.

4. Das Verfahren nach Anspruch 1, wobei die Maske und die Druckplatte derart zusammengefügt sind, dass die Maske sich selbst überlappt.

5. Das Verfahren nach Anspruch 4, wobei die Überlappung der Maske entfernt wird.

6. Das Verfahren nach Anspruch 4, wobei die Überlappung der Maske unter Verwendung einer Trennlinie entfernt wird.

7. Das Verfahren nach Anspruch 1, wobei der erste Zylinder und der zweite Zylinder rotierbar sind.

## Revendications

1. Procédé destiné à réunir un masque et une plaque d'impression, le procédé comprenant les étapes consistant à :
recevoir le masque, le masque possédant une ouverture ;
placer le masque au moins partiellement autour d'un premier cylindre de sorte que l'ouverture du masque soit alignée sur une saillie située sur le premier cylindre ;
réunir le masque et la plaque d'impression au moins en (a) alignant la saillie du premier cylindre sur une entaille située sur un second cylindre, et (b) faisant tourner au moins un cylindre parmi le premier cylindre et le second cylindre ;
et exposer le masque et la plaque d'impression réunis à un rayonnement afin de former l'image dans ou sur la plaque d'impression ;
dans lequel le masque possède une image qui est formée dans celui-ci ou sur celui-ci par ablation laser avant ou après la mise en place du masque au moins partiellement autour du premier cylindre ;
et dans lequel la plaque d'impression est formée au moins partiellement autour du second cylindre.

2. Procédé selon la revendication 1, comprenant en outre l'étape consistant à séparer le masque de la plaque d'impression après exposition au rayonnement.

3. Procédé selon la revendication 1, dans lequel le rayonnement est un rayonnement ultraviolet.

4. Procédé selon la revendication 1, dans lequel le masque et la plaque d'impression sont réunis de sorte que le masque se superpose sur lui-même.

5. Procédé selon la revendication 4, dans lequel la superposition de masque est retirée.

6. Procédé selon la revendication 4, dans lequel la superposition de masque est retirée à l'aide d'une ligne de découpe.

7. Procédé selon la revendication 1, dans lequel le premier cylindre et le second cylindre peuvent tourner.
